Europäisches Patentamt

(19) European Patent Office

Office européen des brevets

(11) Numéro de publication : **0 180 680**
**B1**

(12) **FASCICULE DE BREVET EUROPÉEN**

(45) Date de publication du fascicule du brevet :
**17.05.89**

(21) Numéro de dépôt : **84402236.8**

(22) Date de dépôt : **07.11.84**

(51) Int. Cl.⁴ : **H 03 K 21/12, G 01 D 5/245**

(54) Circuit de comptage destiné en particulier à être associé à un capteur incrémental et apte à coopérer avec un calculateur à huit ou seize caractères binaires.

(43) Date de publication de la demande :
**14.05.86 Bulletin 86/20**

(45) Mention de la délivrance du brevet :
**17.05.89 Bulletin 89/20**

(84) Etats contractants désignés :
**CH DE GB IT LI**

(56) Documents cités :
**DE—A— 2 063 853**
**FR—A— 2 477 808**
**GB—A— 2 021 823**
**US—A— 4 123 750**

(73) Titulaire : **NUM S.A. (Société anonyme)**
**323, Rue de la Garenne**
**F-92005 Nanterre Cedex (FR)**

(72) Inventeur : **Allain, Michel**
**1, rue Monge**
**F-92800 Puteaux (FR)**

(74) Mandataire : **Marquer, Francis et al**
**CABINET MOUTARD 35, avenue Victor Hugo Résidence Champfleury**
**F-78180 Voisins-le-Bretonneux (FR)**

## Description

L'invention se rapporte aux dispositifs appelés « capteurs incrémentaux », qui émettent des impulsions électriques en nombre proportionnel à un déplacement, et aux appareils électroniques de comptage qui leur sont associés. Les capteurs incrémentaux émettent généralement des trains de signaux rectangulaires symétriques, obtenus par défilement d'encoches ménagées à la périphérie d'un disque entraîné en rotation entre une source de lumière et une cellule photo-électrique, cette rotation étant liée au déplacement de l'organe dont on veut contrôler la position. Pour réaliser un capteur bi-directionnel, on prévoit un deuxième ensemble source de lumière-cellule photo-électrique dont la position est décalée, par rapport à un premier ensemble, d'un nombre entier de pas d'encoches, plus ou moins un quart de pas. On obtient ainsi un deuxième train de signaux rectangulaires décalé de 90° dans un sens ou dans l'autre par rapport au premier train.

L'utilisation de ces capteurs nécessite souvent le repérage d'un point particulier du disque, pour définir le déplacement par rapport à une position fixe dans un tour de l'axe de rotation. Cette position, parfois nommée « zéro capteur », est matérialisée, comme cela se trouve décrit dans le brevet DE-A-2 063 853, par une impulsion qui apparaît une fois par tour du disque. Lorsque ces capteurs sont utilisés pour mesurer des déplacements comportant plusieurs tours, il est en outre nécessaire de définir une zone particulière dans laquelle se situera l'origine du déplacement. Cette zone est marquée par un signal extérieur au capteur incrémental. L'appareil électronique qui compte les impulsions issues du capteur utilise l'état actif de ce signal, combiné à l'impulsion de « zéro capteur », pour indiquer que l'origine du déplacement est atteinte.

Les appareils de comptage associés à ces capteurs sont généralement eux-mêmes associés à des calculateurs électroniques numériques ayant le plus souvent des mots de huit ou de seize caractères binaires.

Dans l'art antérieur, l'appareil de comptage était réalisé à l'aide de plusieurs circuits électroniques et ne pouvait être utilisé que par un calculateur ayant une longueur de mots unique, par exemple soit huit, soit seize caractères binaires.

La présente invention a pour objet un circuit électronique de comptage plus particulièrement destiné à être associé à un capteur incrémental et présentant l'avantage d'être contenu dans un seul boîtier et apte à être relié indifféremment à des calculateurs ayant une longueur de mots de huit ou de seize caractères binaires par personnalisation d'une technique de multiplexage d'un type similaire à celles qui se trouvent décrites dans les brevets FR-A-2 477 808 et GB-A-2 021 823.

La taille réduite de ce circuit permet de le réaliser sous la forme d'un circuit intégré.

Pour parvenir à ces résultats, l'invention propose un dispositif pour le comptage des signaux de sortie d'un capteur incrémental fournissant deux signaux de sortie A et B en quadrature ainsi qu'un signal zéro engendré à chaque tour, un signal de butée BUT étant fourni par des moyens extérieurs pour une zone déterminée du déplacement, ce dispositif comprenant en outre des moyens permettant d'effectuer le transfert du résultat de ce comptage à un calculateur numérique dont la mémoire est organisée en mots qui peuvent comporter un premier et un second nombre de caractères binaires, le second nombre étant la moitié du premier, ledit dispositif comprenant, réalisables sous la forme d'un circuit intégré logé dans un boîtier de petites dimensions :

des moyens de synchronisation des signaux A et B fournis par le capteur,

un circuit effectuant le comptage ou le décomptage des signaux A et B, après synchronisation, selon que le signal A est en avance sur le signal B ou l'inverse,

une mémoire pour le stockage du compte,

des organes pour le transfert des informations contenues dans la mémoire au calculateur, ces moyens comprenant deux voies aptes à transmettre chacune le second nombre de caractères, la première voie n'étant raccordable qu'aux sorties de la mémoire qui correspondent aux caractères binaires de poids faible, tandis que la seconde voie est raccordable dans un premier état aux sorties de la mémoire correspondant aux caractères binaires de poids fort, et dans un second état aux sorties de la mémoire correspondant aux caractères binaires de poids faible, le raccordement à la mémoire du calculateur organisé en mots ayant le premier nombre de caractères binaires s'effectuant en établissant le premier état et en utilisant simultanément les deux voies pour le transfert des données, tandis que le raccordement à la mémoire d'un calculateur ayant le second nombre de caractères binaires s'effectue au moyen de la seule seconde voie et en établissant successivement le premier et le second états.

Selon l'invention, ce dispositif est plus particulièrement caractérisé en ce qu'il comprend en outre :

des moyens d'engendrer un premier signal binaire EBUT indicatif de l'état du signal de butée,

des moyens d'engendrer un second signal binaire (signal d'origine) BUTZ indicatif d'une coïncidence d'états entre le signal de butée BUT et le signal de zéro,

des moyens de stocker les signaux EBUT et BUTZ aux adresses mémoire correspondant aux deux caractères de poids le plus fort,

des moyens aptes à provoquer, en réponse à un signal d'initialisation externe RZ, la remise à zéro des organes de synchronisation et de la mémoire et pour engendrer un signal RZ' de remise à zéro des moyens de comptage, à la suite de l'émission par le calculateur d'un signal de validation VALBUT lorsque ledit calculateur requiert la transmission du signal d'origine, les signaux BUT et ZERO n'étant pris en compte pour provoquer la remise à zéro du compteur lorsque l'origine est atteinte que si le signal VALBUT est émis, le signal BUT n'étant transmis que quand le signal ZERO est actif, l'état bas du signal RZ ayant pour effet de mettre le signal BUTZ à zéro et de mettre le signal RZ' à zéro, donc de forcer la remise à zéro du compteur, quel que soit l'état du signal VALBUT de manière à pouvoir modifier l'origine des déplacements du capteur selon le besoin.

L'invention sera mieux comprise à l'aide de la description ci-après :

Au dessin annexé :

La figure 1 est un schéma de principe d'un dispositif de comptage conforme à l'invention ;

Les figures 2A à 2D illustrent le détail des circuits d'un tel dispositif, dans un mode d'exécution préféré ; et

La figure 3 représente les formes d'ondes relevées en différents points desdits circuits.

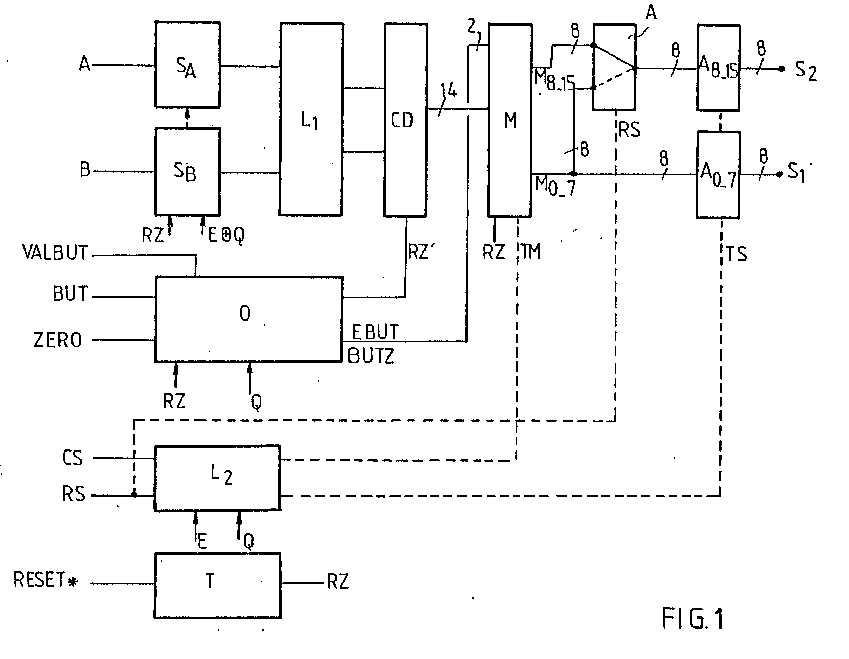

A la figure 1, on a indiqué en A et B les entrées de trains de signaux rectangulaires décalés de 90° l'un par rapport à l'autre qui sont engendrés par un capteur incrémental. Ces signaux sont appliqués à deux organes de synchronisation $S_A$ et $S_B$, eux-mêmes reliés à un circuit logique $L_1$ agencé pour donner quatre impulsions par période des signaux A et B, ces quatre impulsions étant respectivement synchronisées sur les fronts montants et sur les fronts descendants d'une horloge obtenue, comme on l'expliquera dans la suite, à partir de deux signaux en quadrature Q et E.

Les signaux ainsi obtenus sont comptés ou décomptés, en fonction du sens de rotation, c'est-à-dire suivant que A est en avance sur B ou l'inverse, par un compteur-décompteur CD. La sortie du compteur s'effectue sur quatorze caractères binaires $M_0$ à $M_{13}$, qui sont transmis à une mémoire M, en même temps que deux caractères binaires $M_{14}$-$M_{15}$ fournis par un circuit d'indication d'origine O, comme on l'expliquera dans la suite.

Les huit caractères binaires de poids faibles $M_0$-$M_7$ stockés en mémoire sont transmis par un circuit d'aiguillage $A_{07}$ à un premier ensemble de sorties $S_1$, tandis que les huit caractères binaires de poids forts $M_8$-$M_{15}$ sont transmis par un circuit d'aiguillage $A_{8\text{-}15}$ à un second ensemble de sorties $S_2$. Lorsque le microprocesseur est capable de lecture sur seize caractères binaires, l'ensemble des sorties $S_1$ et $S_2$ est raccordé à son bus de données.

Lorsque le microprocesseur lit par octets, seules les sorties $S_2$ sont raccordées à son bus de données.

Un signal RS, fourni par le microprocesseur, est à zéro dans le premier cas, à 1 dans le second. Lorsque RS = 0, à chaque accès du microprocesseur à la mémoire M, celle-ci est rafraîchie et l'ensemble de son contenu est lu par le microprocesseur sur $S_1$-$S_2$.

Lorsque RS = 1, le contenu de la mémoire M n'est pas modifié d'un accès au suivant et, par ailleurs, seule la sortie $S_2$ lui est raccordée. Il en résulte que, quel que soit le temps qui sépare deux accès successifs, le microprocesseur lit les huit caractères binaires de poids forts transmis en $S_2$ au premier accès, puis les huit caractères binaires de poids faibles, transmis à la fois en $S_1$ et en $S_2$, au second accès, grâce à un circuit d'aiguillage A commuté par RS de façon à réaliser par second accès, la liaison figurée en pointillés lorsque RS = 1.

Pour obtenir le fonctionnement qui précède, un circuit logique $L_2$ de commande des transferts reçoit les horloges E et Q, le signal RS et un autre signal CS fourni par le microprocesseur et engendre, comme on l'expliquera dans la suite, un signal TM de commande du transfert du contenu du compteur dans la mémoire, et un signal TS de transfert du contenu de la mémoire sur le bus de sortie.

Comme on l'a expliqué ci-dessus, à chaque tour du disque, le capteur incrémental fournit un signal « ZERO », tandis qu'un signal extérieur au capteur, que l'on a appelé « BUT », est fourni, par exemple par un micro-contact coopérant avec une came, pour une zone particulière de la course. Le signal BUT, après mise en forme dans le circuit 0, est transmis (caractère EBUT) à la mémoire M, à l'adresse du 14ème caractère binaire $M_{14}$. Ce signal EBUT donne au processeur l'information que la butée est déjà atteinte, ce qui lui évite de valider la remise à zéro du compteur lorsqu'il en est ainsi. Par ailleurs, la coïncidence entre les états actifs des deux signaux BUT et ZERO, qui indique que l'origine du déplacement est atteinte, est effectuée par le circuit 0, qui fournit ainsi un signal dit « d'origine », lui-même validé par un signal VALBUT envoyé par le microprocesseur au moment où celui-ci requiert la transmission du signal d'origine. On obtient ainsi un caractère BUTZ, qui n'est d'ailleurs actif que lorsque l'horloge Q passe à 1 et est transmis à l'adresse du caractère $M_{15}$ dans la mémoire. Un signal d'initialisation externe RESET est appliqué à un trigger T qui le met en forme pour donner un signal RZ, appliqué aux organes $S_A$, $S_B$ et M pour leur remise à zéro. Le trigger permet d'accepter des signaux d'initialisation à fronts lents. Le signal RZ est également appliqué au circuit 0, pour donner un signal RZ' de remise à zéro du compteur lorsque le processeur émet le signal de validation VALBUT, comme on l'expliquera dans la suite.

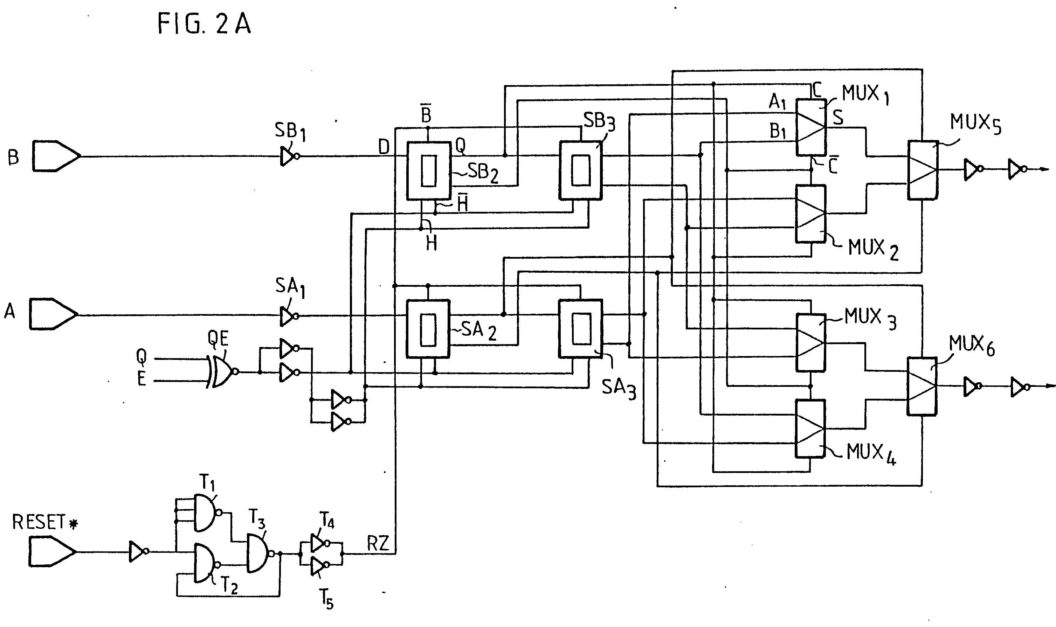

Une forme d'exécution préférée du dispositif que l'on vient de décrire est illustrée par les figures 2A à 2D.

Les signaux A et B sont transmis, par des inverseurs logiques $S_{A1}$ et $S_{B1}$, à des bascules $S_{A2}$ et $S_{B2}$ du type BDR, dont les sorties Q sont reliées aux entrées D de bascules du même type, $S_{A3}$ et $S_{B3}$ respectivement. $S_{A2}$ et $S_{A3}$ constituent le circuit de synchronisation $S_A$ de la figure 1, $S_{B2}$ et $S_{B3}$ le circuit de synchronisation $S_B$.

Le signal RESET mentionné ci-dessus, mis en forme par un trigger $T_1$-$T_5$, est appliqué aux entrées $\bar{R}$ des bascules $S_{A2}$-$S_{A3}$ et $S_{B2}$-$S_{B3}$. Les entrées H et $\bar{H}$ de ces bascules reçoivent la combinaison, dans un OU EXCLUSIF à sortie inverseuse QE, des signaux Q et E, (dont la fréquence se trouve ainsi multipliée par deux), à travers un inverseur supplémentaire pour $\bar{H}$.

Dans la suite de la description, les circuits inverseurs figurés au dessin ne seront pas mentionnés, sauf dans la mesure nécessaire à la compréhension du fonctionnement.

Le circuit logique $L_1$ mentionné ci-dessus est composé de six opérateurs de multiplexage $MUX_1$ à $MUX_0$, dont chacun réalise la fonction $S = A_1 \cdot C + B_1 \cdot \bar{C}$. La signification de ces symboles apparaît sur $MUX_1$.

On peut montrer que l'on produit ainsi, aux sorties S de $MUX_5$ et $MUX_6$, des signaux qui représentent deux fronts d'ondes pour chacun des créneaux A ou, respectivement B et qu'il s'agit de compter pour la voie $MUX_5$ (représentative d'une avance de A sur B), de décompter pour la voie $MUX_6$ (représentative d'une avance de B sur A).

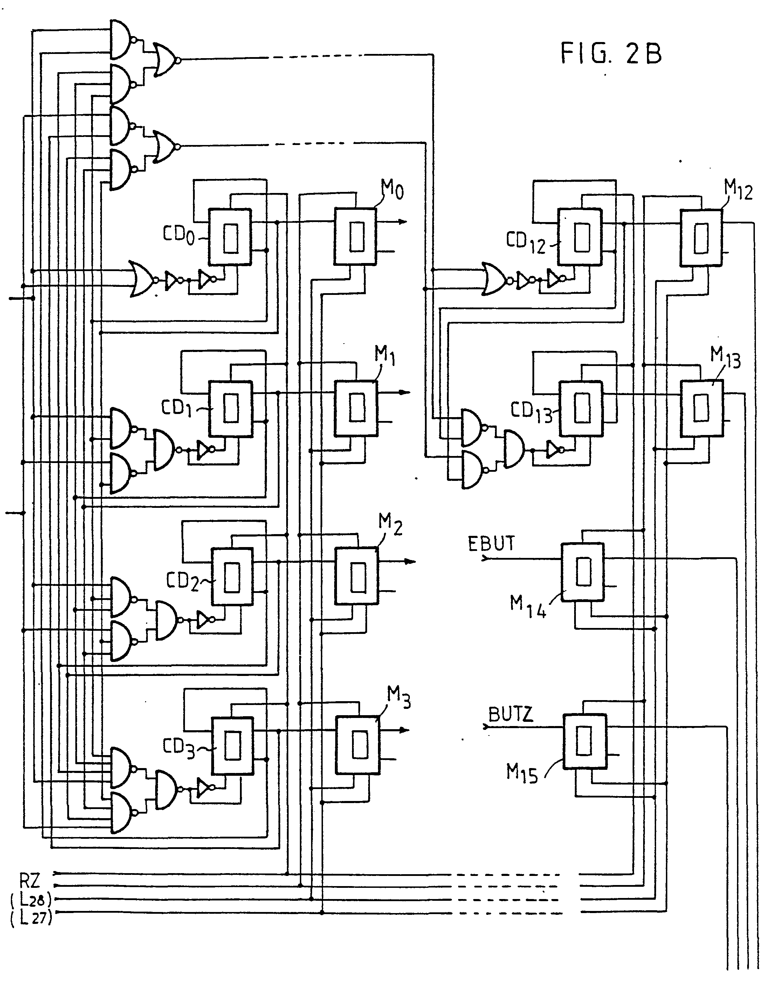

A la figure 2B, on a représenté un premier groupe de quatre bascules du type BDR, désignées $CD_0$ à $CD_3$ et un dernier groupe de deux bascules $CD_{12}$ et $CD_{13}$. Ces deux groupes de bascules constituent respectivement le premier et le dernier étage d'un compteur-décompteur à quatre étages apte à fournir un compte sur quatorze caractères binaires et dont on a omis au dessin les deux étages intermédiaires de quatre bascules. Ces caractères binaires sont transférés dans une mémoire comportant un nombre identique de bascules BDR, respectivement associées à celles respectives du compteur et désignées $M_0$ à $M_{13}$. La mémoire comporte en outre deux bascules supplémentaires $M_{14}$ et $M_{15}$ recevant l'information d'origine sous la forme des deux caractères binaires EBUT et BUTZ mentionnés ci-dessus.

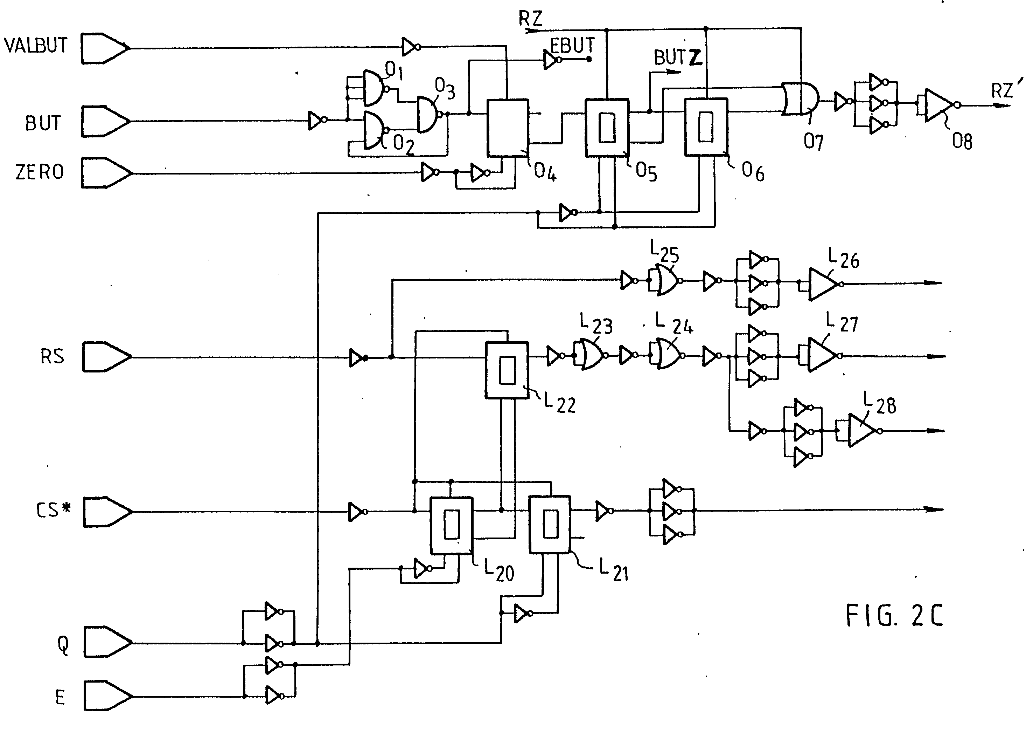

On a représenté, à la figure 2C, les éléments $0_1$ à $0_8$ du circuit logique 0 qui fournit l'information d'origine. $0_1$ à $0_3$ sont des portes ET inverseuses, $0_4$ est une bascule BDSB, $0_5$ et $0_6$ sont des bascules BDR, $0_7$ est la combinaison d'une porte OU et d'une porte ET inverseuse, $0_8$ est un amplificateur. Le signal RZ déjà mentionné est appliqué aux entrées $\bar{R}$ des bascules $0_5$ et $0_6$ et à une des entrées ET de $0_7$. EBUT est recueilli à la sortie de $0_3$, BUTZ à la sortie de $0_5$. A la sortie de $0_8$, on recueille un signal RZ' qui est appliqué aux entrées $\bar{R}$ des bascules $CD_0$ à $CD_{13}$ du compteur.

On voit que l'entrée H de $0_5$ et de $0_6$ reçoit le signal Q et l'entrée $\bar{H}$, le signal $\bar{Q}$.

A la figure 2C, on a représenté également le circuit de commande des transferts ($L_2$, figure 1), composé de bascules BDR désignées $L_{20}$ à $L_{22}$, de portes OU inverseuses désignées $L_{23}$ à $L_{25}$ et de tampons désignés $L_{26}$ à $L_{28}$ (les inverseurs n'étant pas mentionnés, pour simplifier). On voit que l'horloge E est appliquée à l'entrée H de $L_{20}$, tandis que l'horloge Q est appliquée à l'entrée $\bar{H}$ de $L_{21}$. La sortie de $L_{27}$ est appliquée aux entrées $\bar{H}$ des bascules $M_0$ à $M_{13}$, celle de $L_{28}$ aux entrées H desdites bascules.

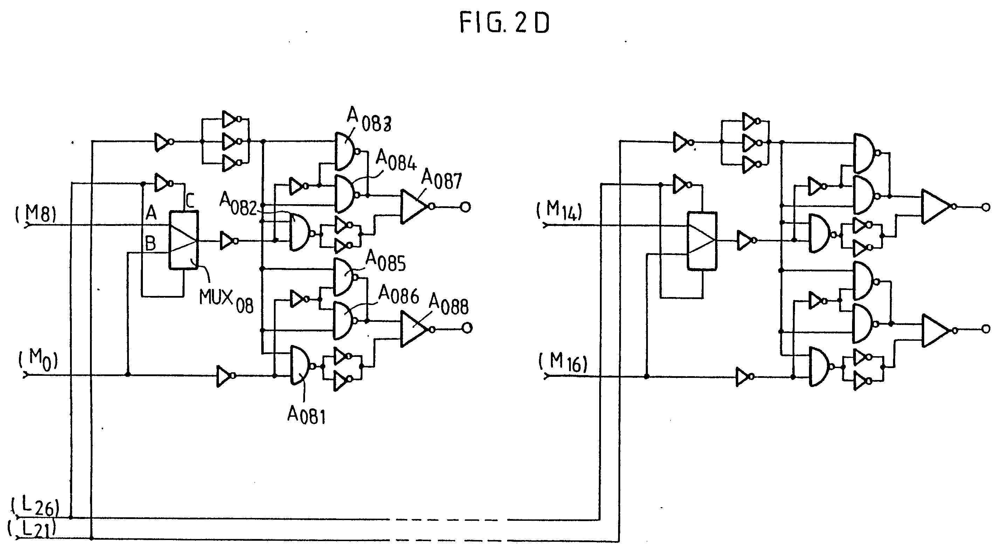

A la figure 2D, on a représenté partiellement les circuits qui remplissent la fonction des aiguillages A et $A_{07}$-$A_{8-15}$ de la figure 1. Un premier circuit, dont les sorties correspondent aux caractères binaires $M_0$-$M_8$, comprend, en plus d'inverseurs logiques non désignés, un opérateur $MUX_{08}$ du type déjà mentionné, six portes ET inverseuses $A_{081}$ à $A_{086}$ et deux amplificateurs inverseurs, $A_{087}$ et $A_{088}$. L'entrée $A_8$ de $MUX_{08}$ est reliée à la sortie Q de la bascule de mémoire $M_8$ (non représentée à la figure 2B), tandis que l'entrée $B_8$ est reliée à la sortie Q de $M_0$. L'entrée C de $MUX_{08}$ est reliée à la sortie de $L_{26}$ (figure 2C) à travers un inverseur, tandis que l'entrée $\bar{C}$ est directement reliée à la sortie de $L_{26}$.

Il est clair que, lorsque RS = 0, donc $L_{26}$ = 0, la sortie de $MUX_{08}$ est égale à $M_8$, tandis que, lorsque $R_S$ = $L_{26}$ = 1, la sortie de $MUX_{08}$ est égale à $M_0$.

Une entrée des portes $A_{081}$ à $A_{086}$ est directement reliée à la sortie de $L_{21}$. Ces portes reçoivent, sur leur autre entrée, soit $\bar{M}_0$ ($A_{81}$), soit $M_0$ ($A_{85}$ et $A_{86}$), soit sortie $\overline{MOX_{08}}$ ($A_{82}$), soit sortie $MUX_{08}$ ($A_{83}$ et $A_{84}$). Par conséquent lorsque $L_{21}$ = 1, pour $R_S$ = 0 et compte tenu des inversions logiques, on recueille $M_8$ à la sortie de $A_{087}$ et $M_0$ à la sortie de $A_{088}$, tandis que, pour $R_S$ = 1, on recueille $M_0$ sur les sorties de $A_{087}$ et $A_{088}$.

Lorsque $L_{21}$ = 0, les portes $A_{081}$ à $A_{086}$ se trouvent bloquées, mettant les deux amplificateurs $A_{087}$ et $A_{088}$ dans un état dit de « haute impédance ».

Un second circuit identique à celui que l'on vient de décrire transmettra les sorties $M_1$ ou $M_9$, un troisième les sorties $M_2$ ou $M_{10}$, un quatrième les sorties $M_3$ ou $M_{13}$, un cinquième les sorties $M_4$ ou $M_{12}$, un sixième les sorties $M_5$ ou $M_{13}$, un septième les sorties $M_6$ ou $M_{14}$ et un huitième les sorties $M_7$ ou $M_{15}$. Seuls les premier et septième circuits ont été représentés à la figure 2D.

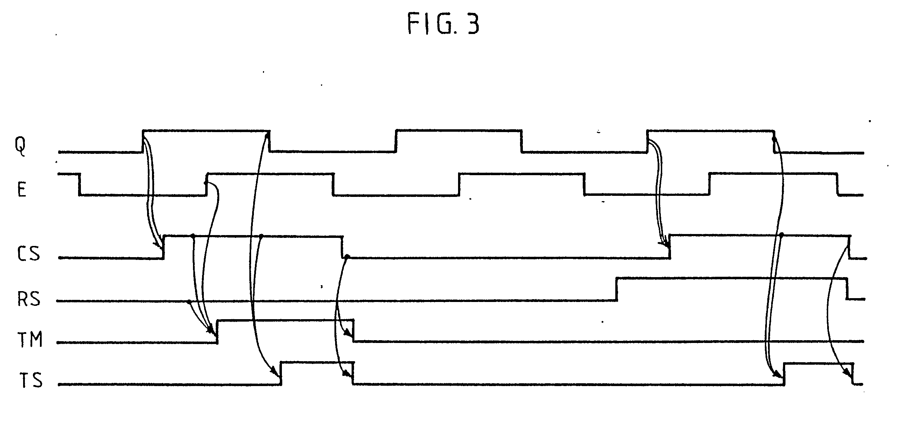

En se référant à la figure 3, on y voit tout d'abord les signaux d'horloge en quadrature Q et E, puis un signal CS que le processeur émet systématiquement après un front montant de Q. On a représenté en TS le signal de sortie $L_{21}$, figure 2C. Lorsque CS est à zéro, la sortie de la bascule $L_{20}$ devient active dès que E passe à 1 et celle de la bascule $L_{21}$ devient ensuite active lorsque Q passe à 0, donnant ainsi TS = 1. Le signal RS est recueilli à la sortie de $L_{26}$. A la sortie de $L_{28}$, on recueille le signal RS, validé par le passage de la sortie de $L_{20}$ à l'état actif ; ce signal $L_{28}$ est le signal TM qui commande le transfert du contenu du compteur dans la mémoire. Lorsque le processeur travaille sur seize caractères binaires, comme RS reste à zéro, à chaque signal CS, TM monte alors à un et, par conséquent, la mémoire est rafraîchie. Lorsque le processeur travaille sur huit caractères binaires, RS passe à un après un premier transfert de données sur le bus et alors, TM ne montant pas, il n'y a pas de transfert de nouvelles données en mémoire. En outre, les opérateurs $MUX_{08}$ du circuit de la figure 2D étant alors commutés, les caractères de poids faibles qui restent en mémoire sont transférés sur le bus.

Revenant à la figure 2C, comme on l'a expliqué ci-dessus, les entrées BUT et ZERO ne sont prises en compte, pour provoquer la remise à zéro du compteur lorsque l'origine est atteinte que si VALBUT = 1, la bascule $0_4$ transmettant alors le signal BUT quand ZERO est actif. Par ailleurs, l'état bas du signal RZ, appliqué à la bascule $0_5$, a pour effet de mettre BUTZ à zéro et de mettre RZ' à 0, donc de forcer la remise à zéro du compteur, quel que soit l'état de VALBUT, ce qui sert à modifier l'origine si on le désire.

On notera que l'utilisation de deux signaux d'horloge Q et E de même fréquence et en quadrature pour établir la synchronisation des différents circuits, à l'exclusion des circuits de synchronisation des signaux d'entrée $S_A$ et $S_B$ et l'utilisation d'un signal d'horloge de fréquence double obtenu à partir de Q et E, permettent d'améliorer notablement la performance des circuits d'entrée.

**Revendications**

1. Dispositif pour le comptage des signaux de sortie d'un capteur incrémental fournissant deux signaux de sortie (A et B) en quadrature ainsi qu'un signal ZERO engendré à chaque tour, un signal de butée BUT étant fourni par des moyens extérieurs pour une zone déterminée du déplacement, ce dispositif comprenant en outre des moyens permettant d'effectuer le transfert du résultat de ce comptage à un calculateur numérique dont la mémoire est organisée en mots qui peuvent comporter un premier ou un second nombre de caractères binaires, le second nombre étant la moitié du premier, ledit dispositif comprenant, réalisables sous la forme d'un circuit intégré logé dans un boîtier de petites dimensions :
   des moyens de synchronisation (SA, SB) des signaux (A et B) fournis par le capteur,
   un circuit (CD) effectuant le comptage ou le décomptage des signaux (A et B), après synchronisation, selon que le signal (A) est en avance sur le signal (B) ou l'inverse,
   une mémoire (M) pour le stockage du compte,
   des organes pour le transfert des informations contenues dans la mémoire au calculateur, ces moyens comprenant deux voies ($S_1$, $S_2$) aptes à transmettre chacune le second nombre de caractères, la première voie n'étant raccordable qu'aux sorties de la mémoire qui correspondent aux caractères binaires de poids faible, tandis que la seconde voie est raccordable dans un premier état aux sorties de la mémoire correspondant aux caractères binaires de poids fort, et dans un second état aux sorties de la mémoire correspondant aux caractères binaires de poids faible, le raccordement à la mémoire du calculateur organisé en mots ayant le premier nombre de caractères binaires s'effectuant en établissant le premier état et en utilisant simultanément les deux voies pour le transfert des données, tandis que le raccordement à la mémoire d'un calculateur ayant le second nombre de caractères binaires s'effectue au moyen de la seule seconde voie et en établissant successivement le premier et le second états, caractérisé en ce qu'il comprend en outre :
   des moyens (0) d'engendrer un premier signal binaire EBUT indicatif de l'état du signal de butée,
   des moyens d'engendrer un second signal binaire BUTZ indicatif d'une coïncidence d'états entre le signal de butée BUT et le signal ZERO,
   des moyens de stocker les signaux EBUT et BUTZ aux adresses mémoire correspondant aux deux caractères de poids le plus fort ($M_{14}$, $M_{15}$),
   des moyens aptes à provoquer, en réponse à un signal d'initialisation externe RZ, la remise à zéro des organes de synchronisation (SA, SB) et de la mémoire (M) et pour engendrer un signal RZ' de remise à zéro des moyens de comptage, à la suite de l'émission par le calculateur d'un signal de validation VALBUT lorsque ledit calculateur requiert la transmission du signal BUTZ, les signaux BUT et ZERO n'étant pris en compte pour provoquer la remise à zéro du compteur lorsque l'origine est atteinte que si le signal VALBUT est émis, le signal BUT n'étant transmis que quand le signal ZERO est actif, l'état bas du signal RZ ayant pour effet de mettre le signal BUTZ à zéro et de mettre le signal RZ' à zéro, donc de forcer la remise à zéro du compteur, quel que soit l'état du signal VALBUT de manière à pouvoir modifier l'origine des déplacements du capteur selon le besoin.

2. Dispositif selon la revendication 1, caractérisé par une première et une seconde horloges (Q et E) de même fréquence et en quadrature l'une par rapport à l'autre, ces deux horloges assurant la synchronisation des transferts de données entre le circuit de comptage et la mémoire (signaux TM) et entre la mémoire et le calculateur (signaux TS) et par des moyens (QE) d'engendrer la fonction OU EXCLUSIF des deux signaux d'horloge pour synchroniser les signaux (A et B) issus du capteur incrémental.

3. Dispositif selon la revendication 2, dans lequel le susdit second nombre est la moitié du premier et les susdits organes de transfert comprennent deux voies aptes à transmettre chacune le second nombre de caractères, la première voie ($A_{0-7}$, $S_1$) n'étant raccordable qu'aux sorties ($M_{07}$) de la mémoire qui correspondent aux caractères binaires de poids faibles, tandis que la seconde voie (A, $A_{8-15}$, $S_2$) est raccordable, dans un premier état aux sorties de la mémoire ($M_{8-15}$) correspondant aux caractères binaires de poids forts et, dans un second état, aux sorties ($M_{0-7}$) de la mémoire correspondant aux caractères binaires de poids faibles, le raccordement à la mémoire d'un calculateur organisé en mots ayant le premier nombre de caractères binaires s'effectuant en établissant le premier état et en utilisant simultanément les deux voies pour le transfert des données, tandis que le raccordement à la mémoire d'un calculateur organisé en mots ayant le second nombre de caractères binaires s'effectue au moyen de la seule seconde voie et en établissant successivement le premier et le second états, caractérisé en ce que, le calculateur engendrant un signal (CS) d'activation de l'interface entre la mémoire et le calculateur et un signal (RS) de sélection de la longueur de mots, ledit signal de sélection (RS) commande la commutation de la seconde voie du premier au second état (organe d'aiguillage A), les signaux (TM) de transfert du contenu du circuit de comptage dans la mémoire étant activés seulement lorsque ledit signal de sélection est tel que la seconde voie soit dans le premier état et lorsque ledit signal d'activation (CS) est actif.

4. Dispositif selon la revendication 3, caractérisé en ce que la validation du transfert de données entre le circuit de comptage et la mémoire (signaux TM) est obtenue en validant ledit signal d'activation (CS) par un front montant de la seconde horloge (E).

5. Dispositif selon la revendication 4, caractérisé en ce que la validation du transfert de données entre la mémoire et le calculateur (signaux TS) est obtenue en validant successivement ledit signal d'activation (CS) par un front montant de la seconde horloge (E) et par un front descendant de la première horloge (Q).

**Claims**

1. A device for counting the output signals from an incremental sensor supplying two output signals (A and B) in quadrature as well as a signal ZERO on each revolution, and an end signal BUT being produced by external means for a particular displacement zone, this device further comprising means for transferring the result of said count to a digital computer whose memory is organized in words which may comprise a first or a second number of bits, the second number being half of the first one, said device comprising, possibly in the form of an integrated circuit housed in a case of small dimensions :

synchronisation means (SA, SB) of the signals (A and B) supplied by the sensor,

a circuit (CD) counting or decounting the signals (A and B) after synchronisation, depending on the fact that the signal (A) is ahead of signal (B) or inversely,

a memory (M) for storing the count, members for transferring the information contained in the memory to the computer, these means comprising two paths ($S_1$, $S_2$) each adapted to transmit the second number of data, the first path being only connectable to the memory outputs corresponding to the least significant bits, whereas the second path can be connected in a first state to the memory outputs corresponding to the most significant bits and in a second state to the outputs of the memory corresponding to the less significant bits, connection to the memory of the computer organised in words having the first number of bits being effected by selecting the first state and by simultaneously using the two paths for the data transfer, whereas connection to the memory of a computer having the second number of bits is effected by means of the second path only and by successively selecting the first and the second states, characterized in that it further comprises :

means (0) for producing a first bit EBUT indicating the state of the end signal,

means for producing a second bit BUTZ indicating a coincidence of states between the end signal BUT and the ZERO signal,

means for storing the signals EBUT and BUTZ at the addresses of the memory corresponding to the two most significant bits ($M_{14}$-$M_{15}$),

means adapted to cause, in response to an external initializing signal RZ, the resetting to zero of the synchronization members (SA, SB) and of the memory (M) and for producing a signal RZ' for resetting to zero of the counting means, following emission, by the computer of a validation signal VALBUT when said computer requires transmission of the signal BUTZ, the signals BUT and ZERO being taken into account for causing resetting to zero of the counter when the origin in reached, only when the signal VALBUT is emitted, the signal BUT being transmitted only when the signal ZERO is active, the low state of the signal RZ causing signal BUT to be set to zero and to set the signal RZ' to zero, and thus to force resetting to zero of the counter, whatsoever the state of the signal VALBUT, so as to be able to modify the origin of movements of the sensor as need be.

2. A device as claimed in claim 1, characterized by a first and a second clock (Q and E) of the same frequency and in quadrature one with respect to the other, these clocks being designed to synchronize date transfers between the counter circuit and the memory (signals TM) and between the memory and the computer (signals TS) and means (QE) for producing the EXCLUSIVE OR function of the two clock signals to synchronize the signals (A and B) from the incremental sensor.

3. A device as claimed in claim 2, in which the above second number is half the first one and said transfer means include two paths, both capable of transmitting the second data set, the first path ($A_{0-7}$, $S_1$) being only connectable to the least significant bit outputs ($M_{0-7}$) of the memory, while the second path (A, $A_{8-15}$, $S_2$) is connectable in a first state to the most significant bit outputs ($M_{8-15}$) of the memory and, in a second state, to the least significant outputs ($M_{0-7}$) of the memory, connection to the memory of a computer with words of the first number of bits being enabled by selecting the first state and by simultaneously using both paths for the date transfer, while, for connection to the memory of a computer with the second number of bits, only path two is used by selecting states one and two successively, characterized in that, when the computer produces a signal (CS) which enables the interface between the memory and the computer, and a signal (RS) to select the length of words, said selection signal (RS) switches the second path from the first to the second state (switching member A), the signals (TM) which transfer the contents of the counter circuit to the memory being only enabled when the said selecting signal is such that the second path is in the first state and when said activation signal (CS) is active.

4. A device as claimed in claim 3, characterized in that the enabling of the data transfer from the counter circuit to the memory (signals TM) is obtained by enabling said activation signal (CS) by a rising edge of the second clock (E).

5. A device as claimed in claim 4, characterized in that the enabling of the data transfer from the memory to the computer (signals TS) is obtained by successively enabling the said activation signal (CS) on a rising edge of clock two (E) and on a trailing edge of clock one (Q).

## Patentansprüche

1. Zählvorrichtung zur Zählung der Ausgangssignale eines Inkrementalgebers, welcher zwei Ausgangssignale in Phasenquadratur (A und B) abgibt, sowie ein bei jedem Umlauf erzeugtes Nullsignal ZERO, wobei ein Endsignal BUT für eine bestimmte Bewegungszone von ausserhalb befindlichen Mitteln abgegeben wird und besagte Zählvorrichtung ausserdem Mittel aufweist, um das Zählergebnis an einen Digitalprozessor weiterzugeben, dessen Speicher in Wörtern organisiert ist, welche eine erste oder eine zweite Anzahl von Bits enthalten können, wobei die zweite Anzahl die Hälfte der ersten Anzahl beträgt und besagte Vorrichtung, die in Form einer, in einem Kasten mit geringen Abmessungen enthaltenen, integrierten Schaltung aufweist :

Mittel (SA, SB) zur Synchronisation der vom Geber abgegebenen Signale (A und B),

einen Schaltkreis (CD), welcher die Aufwärtszählung oder Abwärtszählung der Signale (A und B) nach ihrer Synchronisation, je nachdem das Signal (A) dem Signal (B) voreilt oder umgekehrt, vornimmt,

einen Speicher (M) zur Speicherung des Zählwertes,

Organe zur Weitergabe der im Prozessorspeicher enthaltenen Informationen, wobei diese Mittel zwei Kanäle ($S_1$, $S_2$) aufweisen, die jeweils die zweite Anzahl von Bits weitergeben können und der erste Kanal nur an die Speicherabgaben angeschlossen werden kann, die den geringstwertigen Bits entsprechen, während der zweite Kanal im ersten Zustand an die Speicherabgaben angeschlossen werden kann, die den höchstwertigen Bits entsprechen und in einem zweiten Zustand an die Speicherabgaben, welche den geringstwertigen Bits entsprechen, wobei der Anschluss an den Prozessorspeicher mit Wörtern der ersten Anzahl von Bits bewerkstelligt wird, indem der erste Zustand hergestellt wird und gleichzeitig beide Kanäle zur Datenübermittlung benutzt werden, während der Anschluss an den Prozessorspeicher mit der zweiten Anzahl von Bits nur mittels des zweiten Kanals bewerkstelligt werden kann, indem nacheinander der erste und der zweite Zustand hergestellt werden, dadurch gekennzeichnet, dass sie weiterhin aufweist :

Mittel (0), um ein erstes Bitsignal EBUT zu erzeugen, das den Zustand des Endsignals anzeigt,

Mittel, um ein zweites Bitsignal BUTZ zu erzeugen, das eine Zustandskoinzidenz zwischen dem Endsignal BUTZ und dem Nullsignal ZERO anzeigt,

Mittel, um die EBUT und BUTZ-Signale in den Speicheradressen zu speichern, die den zwei höchstwertigen Bits ($M_{14}$, $M_{15}$) entsprechen,

Mittel, die auf ein von aussen kommendes Initialisierungssignal RZ hin die Nullrückstellung der Synchronisationsorgane (SA, SB) und des Speichers (M) bewirken und die ein Signal RZ' zur Nullrückstellung der Zählmittel erzeugen, nachdem der Prozessor ein Gültigmachungssignal VALBUT abgegeben hat, wenn besagter Prozessor die Übermittlung des BUTZ-Signals fordert, wobei die Signale BUT und ZERO nur berücksichtigt werden, um den Zähler auf Null zurückzustellen, sobald der Anfangspunkt erreicht ist, wenn das Signal VALBUT abgegeben wird und das Signal BUT nur weitergegeben wird, wenn das Signal ZERO aktiv ist, und der Niedrigzustand des Signal RZ die Nullrückstellung der Signale BUTZ und RZ' bewirkt und so die Nullrückstellung des Zählers, unabhängig vom Zustand des Signals VALBUT erzwingt, um den Ausgangspunkt der Geberverschiebungen verändern zu können.

2. Vorrichtung nach Anspruch 1, dadurch gekennzeichnet, dass sie eine erste und eine zweite Uhr (Q und E) aufweist, mit gleicher Frequenz und in Phasenquadratur zueinander, wobei diese beiden Uhren die Synchronisation der Datenübermittlung zwischen dem Zählkreis und dem Speicher (Signale TM) ermöglichen und zwischen dem Speicher und dem Prozessor (Signale TS), und durch Mittel (QE), die die exklusive ODER-Funktion der beiden Uhrensignale erzeugen, um die vom Inkrementalgeber kommenden Signale (A und B) zu synchronisieren.

3. Vorrichtung nach Anspruch 2, in der die besagte zweite Anzahl die Hälfte der ersten beträgt und besagte Übermittlungsorgane zwei Kanäle aufweisen die jeweils die zweite Anzahl von Bits weitergeben können, wobei der erste Kanal ($A_{0-7}$, $S_1$) nur an die Speicherabgaben ($M_{0-7}$) angeschlossen werden kann, die den geringstwertigen Bits entsprechen, während der zweite Kanal (A, $A_{8-15}$, $S_2$) im ersten Zustand an die Speicherabgaben ($M_{8-15}$), welche den höchstwertigen Bits entsprechen, angeschlossen werden kann und, im zweiten Zustand, an die Speicherabgaben ($M_{0-7}$), die den mindestenswertigen Bits entsprechen, und der Anschluss an den Prozessorspeicher mit Wörtern der ersten Anzahl von Bits stattfindet, indem man den ersten Zustand herstellt und gleichzeitig beide Kanäle zur Datenübermittlung benutzt, während der Anschluss an den Prozessorspeicher mit Wörtern der zweiten Anzahl von Bits nur mittels des zweiten Kanals stattfindet und indem man nacheinander den ersten und den zweiten Zustand herstellt, dadurch gekennzeichnet, dass, wenn der Prozessor, welcher ein Signal (CS) zur Aktivierung der Nahtstelle zwischen dem Speicher und dem Prozessor und ein Signal (RS) zur Auswahl der Wortlänge abgibt, das besagte Auswahlsignal (RS) die Führung des zweiten Kanals vom ersten in den zweiten Zustand bewirkt (Schaltorgan A) und die Signale (TW) zur Eingabe des Zählkreisinhalts in den Speicher nur aktiviert werden, wenn besagtes Auswahlsignal so ausgelegt ist, dass der zweite Kanal sich in einem ersten Zustand befindet und wenn besagtes Aktivierungssignal (CS) aktiv ist.

4. Vorrichtung nach Anspruch 3, dadurch gekennzeichnet, dass die Gültigmachung der Datenübermittlung zwischen dem Zählkreis und dem Speicher (Signale TM) dadurch erreicht wird, dass besagtes Aktivierungssignal (CS) durch eine steigende Front der zweiten Uhr (E) gültiggemacht wird.

5. Vorrichtung nach Anspruch 4, dadurch gekennzeichnet, dass die Gültigmachung der Datenübermittlung zwischen dem Speicher und dem Prozessor (Signale TS) dadurch erreicht wird dass besagtes Aktivierungssignal (CS) nacheinander durch die aufsteigende Front einer zweiten Uhr (E) und die absteigende Front einer ersten Uhr (Q) gültiggemacht wird.

FIG.1

EP 0 180 680 B1

FIG. 2A

FIG. 2 B

EP 0 180 680 B1

FIG. 2C

EP 0 180 680 B1

FIG. 2D

FIG. 3

EP 0 180 680 B1